# EUROPEAN PATENT APPLICATION

(11) **EP 4 807 793 A1**
(43) Date of publication of application: **16.09.2026**
(21) Application number: 25162749.3
(22) Date of filing: 10.03.2025
(51) Int. Cl.: H01L 25/07, H01L 23/00, H02M 7/00

(54) **POWER SEMICONDUCTOR MODULE AND USE**

(71) Applicant: Hitachi Energy Ltd, 8050 Zürich (CH)
(72) Inventor: Truessel, Dominik, 5620 Bremgarten (CH); Santolaria, Lluis, 4600 Olten (CH)
(74) Representative: Michalski Hüttermann & Partner mbB

(57) **Abstract**

The invention relates to a power semiconductor module comprising
a substrate structure (10) with a top metallization layer (20) having a first metallization area (21) and a second metallization area (22);
an arrangement of semiconductor devices (30a, 30b) each having a top electrode (31a, 31b) facing away from the substrate structure (10) and a bottom electrode arranged on the first metallization area (21); and
an arrangement of bond structures (50a, 50b) each configured for wiring one of the top electrodes (31a, 31b) to the second metallization area (22) along one of two or more wiring directions (W1, W2), wherein an angle (a_tot) between a first and a second wiring direction (W1, W2) of the two or more wiring directions (W1, W2) is at least 30° and up to 150°,
**characterized by**
an interconnection structure (40) configured for wiring at least two top electrodes (31a, 31b) of the arrangement of semiconductor devices (30a, 30b) directly to one another.

## Description

### Technical Field

The invention relates to a power semiconductor module comprising a substrate structure, semiconductor devices arranged on the substrate structure, and bond structures wiring the semiconductor devices to the substrate structure. The invention further relates to a use.

### Background Art

Bond structures in power semiconductor modules, particularly in submodules thereof, are typically used for wiring top electrodes on a substrate structure. Bond structures can be arranged to assume a wiring direction. In the design of modules, especially substrate design or submodule design, adjusting wiring directions of bond structures can be beneficial regarding compactness and use of space. However, physical characteristics of the power semiconductor module or its submodule, such as electromagnetic coupling inductance and consequently the switching behavior, may be adversely affected when the wiring directions are varied.

### Summary of invention

It is therefore an object of the invention to provide solutions with respect to power semiconductor modules that provide at least one of enhanced compactness and enhanced physical characteristics. Particularly it is an object to avoid or reduce disadvantages of known solutions.

The object of the invention is solved by the features of the independent claims. Preferred implementations are detailed in the dependent claims, the description and the figures.

The object is particularly solved by a power semiconductor module comprising
a substrate structure with a top metallization layer having a first metallization area and a second metallization area;
an arrangement of semiconductor devices each having a top electrode facing away from the substrate structure and a bottom electrode arranged on the first metallization area;
an arrangement of bond structures each configured for wiring one of the top electrodes to the second metallization area along one of two or more wiring directions, wherein an angle between a first and a second wiring direction of the two or more wiring directions is at least 30° and up to 150°; and
an interconnection structure configured for wiring at least two top electrodes of the arrangement of semiconductor devices directly to one another.

The suggestion is based on the idea to have two or more electrically parallel chips with respective bond structures, where main orientations of the bond structures are rotated in respect to each other, wherein the chips are additionally directly interconnected.

In other words, particularly, suggested is a semiconductor module with two or more electrically parallel chips on a substrate. The chips may be electrically connected to the substrate in each case by at least one wire contacting the top side of the respective chip, e.g. the source or emitter of the chip. In a top view, comparing two or more of the chips, the wires of said chips may run substantially non-parallel to one another and/or assume, in a top view, an angle between 30° and 150° with respect to each other. The wires of two or more chips may run in different directions and/or run obliquely, specifically substantially perpendicularly, which can enhance module compactness. Further, two, particularly adjacent, top sides shall be wired directly to one another, e.g. by means of at least one further wire, such that electrical characteristics of the module is enhanced.

As another example, the proposed module comprises a substrate structure carrying a top metallization layer, which includes at least two separate metallization areas. A set of semiconductor devices is mounted on the substrate structure, with each device having a bottom electrode in electrical contact with a first metallization area and a top electrode facing outward. To provide electrical interconnections, source bond structures are used, each linking a top electrode to the second metallization area along different wiring directions, where the angular difference between at least two wiring directions falls within the range of 30° to 150°. Additionally, an interconnection structure is introduced to directly electrically connect at least two top electrodes, enabling at least one of equalization and homogenization of the electrical behavior of the arrangement of semiconductor devices.

The proposed solution is based on the finding that the presence of the angle between the two wiring directions may improve the compactness of the module while possibly adversely affecting electrical characteristics of the module, such as homogeneity of gate coupling inductances. It has been found that the interconnection structure may provide that the electrical characteristics of the module may be kept like if there was no angle or the electrical characteristics or at least are not that much adversely affected while the improved compactness from the angle can be achieved. For example, a gate coupling inductance may be improved, i.e. homogenization of the gate coupling inductances of multiple parallel chips is achieved, when the interconnection structure is adopted. The gate couplings between chips may be balanced.

By means of the invention and by means of aspects described in the present application, and enhanced power semiconductor module is provided which may have a more homogeneous switching behavior and improved thermal properties.

Further advantageous implementations of the invention are given as follows. The features named in the implementations may be individually combined with each other or considered alone.

The power semiconductor module is, for example, meant to be a module in a vehicle to convert direct current from a battery to alternating current for an electric motor, for example, in hybrid vehicles or plug-in electric vehicles, or in a train like a commuter train. The power semiconductor module may be configured to change the frequency of the current. The power semiconductor module may be a module in a railway inverter.

The substrate structure may have an insulation layer with the top metallization layer, and optionally with a bottom metallization layer opposite the top metallization layer. The insulation layer may comprise for electrical insulation a ceramic material and/or a resin sheet, typically filled with inorganic particles or fibers. The insulation layer is typically a dielectric layer, e.g. made of a flexible or of a solid material. The top metallization layer and/or the bottom metallization layer particularly comprises or consists of copper, aluminum or an alloy therewith.

The insulation layer may be a ceramic layer, e.g. comprising at least one type of a ceramic, for example aluminum oxide. The top metallization layer and/or the bottom metallization layer may be a layer attached to and/or coated on the insulation layer. The insulation layer and the metallization layer(s) may be attached to one another, e.g. to form a structural unit. One or both of the metallization layers may be applied and/or generated directly on the insulation layer. The insulation layer may provide structural integrity to the substrate structure, e.g. the insulation layer may be a rigid part. The top metallization layer may provide electrical interconnection of at least the semiconductor devices, and/or the bottom metallization layer may provide heat radiation or dissipation means. In some power semiconductor modules, the bottom metallization layer may provide electrical interconnection.

The top and/or bottom metallization layer may have a coating, e.g. a nickel coating, and/or additional noble metal layer of silver, gold, and/or palladium. The coating and/or additional noble metal layer providing for improved corrosion resistance, improved electrical properties, improved bonding properties and/or reduced cost.

The substrate structure can be provided with the bottom metallization layer and/or a bottom plate of the substrate structure on a lower side, especially for thermally connecting the substrate structure to a cooler or the like.

The semiconductor devices of one arrangement of semiconductor devices (i.e. two or more semiconductor devices) are arranged on the top metallization layer, especially on one metallization area thereof, and typically electrically connected thereto. There may be two or more arrangements of semiconductor devices per metallization area. Semiconductor devices of another arrangement of semiconductor devices may be arranged on the top metallization layer, especially on another metallization area thereof, and typically electrically connected thereto. Generally, an arrangement of semiconductor devices typically includes adjacent semiconductor devices. Semiconductor devices may be adjacent when they are arranged at a distance to one another along the substrate structure by up to twice the size or edge length of the respective semiconductor devices.

The top metallization layer may provide one or more pattern for mounting of (the) semiconductor devices and/or other electronic devices such as sensors, control devices, and/or passive devices and/or for main and auxiliary terminals, particularly external terminals for external connection. The one or more pattern of the top metallization layer may be formed by means of (the) metallization areas.

A semiconductor device may be in the form of a chip. The semiconductor device has the top electrode and the bottom electrode for electrical connection. The top and bottom electrodes can be arranged on opposite flat sides of the semiconductor device. Additionally, the semiconductor device may have a gate electrode, e.g. adjacent to, next to and/or on the side of the top electrode. The semiconductor device may be one or more of a transistor and/or switching device, such as insulated-gate bipolar transistor (IGBT) device, metal oxide semiconductor field-effect transistor (MOSFET), diode, and/or the like.

The power semiconductor module typically comprises one or more submodules, each submodule having a substrate structure with a top metallization layer, a semiconductor device, particularly an arrangement of semiconductor devices, arranged on the top metallization layer, and typically a bond structure for wiring the semiconductor device to the top metallization layer, especially to a second metallization area of the top metallization layer.

All the semiconductor devices of the module or submodule can be of the same/similar type, or there are at least two different types of semiconductor devices, like diodes and/or transistors.

A semiconductor device, e.g. its type, may be selected from the group comprising or consisting of a metal-oxide-semiconductor field-effect transistor, MOSFET for short, a metal-insulator-semiconductor field-effect transistor, MISFET for short, an insulated-gate bipolar transistor, IGBT for short, a bipolar junction transistor, BJT for short, a gate turn-off thyristor, GTO for short, a gate commutated thyristor, GCT for short, a junction gate field-effect transistor, JFET for short, a high electron mobility transistor, HEMT for short, and a diode.

The power semiconductor module for example is configured for high currents. The power semiconductor module may be configured to handle a current of at least 10 A or of at least 50 A or of at least 100 A or of at least 500 A. Correspondingly, a semiconductor device may be high-power device, particularly a high-power chip.

The metallization layer may be in direct contact with the insulation layer. The insulation layer may be the only layer between the top metallization layer and the bottom metallization layer. The substrate structure provides an electrical contact platform for one, for some or for all of the semiconductor devices or the arrangement(s) therewith.

The insulation layer may comprise one or a plurality of ceramic layers. For example, the ceramic layer may comprise an AIN, Si3Ni, Al2O3, BN, or a resin material filled with particles or fibers of inorganic material. The insulation layer may comprise or consist of at least one isolating resin sheet. The insulation layer may be filled with an inorganic filler like inorganic particles. The at least one inorganic filler can be a ceramic material like AIN, Al2O3, Si3N4, or BN.

The top metallization layer may have a thickness of at least 0.1 mm, 0.15 mm, 0.25 mm, 0.5 mm, 0,75 mm, 1 mm or more. The thickness of the top metallization layer may be up to 5 mm, 4 mm, 3 mm, 2 mm, or less. The top metallization layer may be deposited in a coating process, a lamination process and/or a brazing process. The thickness may be a nominal thickness of the metallization layer considered directly after its (raw) manufacture. The top metallization layer may be bonded to the insulation layer and/or may have two or more metallization areas.

The top metallization layer may have an isolation groove between adjacent metallization areas e.g. to form individual electrically conducting sections of the top metallization layer and/or at least one electrical circuit and/or a pattern. The isolation groove may represent a recess in the top metallization layer and/or a locally removed section of the top metallization layer. The isolation groove may be filled with a material different from the top metallization layer and/or with isolating material. The isolation groove may at least substantially and/or sectionally comprise a certain depth. More than one isolation groove may be provided. The isolation groove and/or the individual electrically conducting sections may be understood as a topography or pattern of the substrate structure. The isolation groove may have a depth of at least 0.1 mm, 0.15 mm, 0.25 mm, 0.5 mm, 0,75 mm, 1 mm or more. The depth of the isolation groove may correspond to the thickness of the top metallization layer or may be more than that, e.g. the isolation groove extending into the insulation layer.

A bond structure may comprise one or more conductors, wires or bonds. Each bond structure may have, for example, up to twenty conductors, wires or bonds. Each bond structure is configured for wiring a top electrode to the second or third or another metallization area along a wiring direction and, for example, across an isolation groove. Particularly, each bond structure is configured for wiring a top electrode to a metallization area different from the metallization area on which the semiconductor device is arranged.

Each of the one or more conductors of a bond structure may follow an individual path or direction. The wiring direction may be evident or derivable in a top view, e.g. as an average or equalization of the individual path(s) or direction(s) of (the) one or more conductors of a bond structure. In other words, particularly, the wiring direction of one bond structure may be an average direction which can be calculated or estimated based on the individual form and/or direction of the conductors of said bond structure e.g. as seen from the top. The wiring direction may be referred an imaginary path. The one or more conductors, e.g. one, some, or all thereof, may or may not exactly follow and/or run in parallel to the wiring direction. Each bond structure may have one wiring direction, particularly exactly one wiring direction; that is, an arrangement of bond structures may have a number of wiring directions corresponding to the number of bond structures, particularly exactly corresponding thereto.

Typically, there is one arrangement of bond structures per arrangement of semiconductor devices. Among an arrangement of semiconductor devices, each semiconductor device is typically wired by means of one bond structure of the arrangement of bond structures to the second or third or another metallization area along a wiring direction. The wiring direction may be evident in a top view. That is, there may two or more wiring directions, particularly of which at least two wiring directions are different or non-parallel. An angle between wiring directions may be approx. 90° or 90° ± 10°. For example, two or more chips are wired electrically in parallel to the substrate structure but along different wiring directions in order to achieve compactness.

Specifically, the angle between the first and the second wiring directions may be at least 60° and/or up to 120°. The angle may be 90° ± 60°, or 90° ± 40°, or 90° ± 30°, or 90° ± 20°, or 90° ± 10°.

The interconnection structure wires two or more top electrodes of one arrangement of semiconductor devices directly to one another. For example, there is a direct connection by means of the interconnection structure between adjacent or neighbouring top electrodes of an arrangement of semiconductor devices. Although the top electrodes are typically wired electrically in parallel via respective bond structures, the interconnection structure can provide a more direct connection and thereby an improvement of electrical and/or thermal characteristics of the module.

One interconnection structure may be assigned to one arrangement of semiconductor devices. There may be one interconnection structure per arrangement of semiconductor devices. There may be two or more interconnection structures, e.g. one interconnection structure per arrangement of semiconductor devices.

The interconnection structure may be configured for wiring the second metallization area directly to one of the top electrodes, e.g. electrically in parallel to the bond structure but typically along another direction. The interconnection structure may at least in a section run electrically in parallel to the bond structures, and may in another section connect with a second or third metallization area. Specifically, the interconnection structure may be configured for wiring the second metallization area directly to another one of the top electrodes. For example, the interconnection structure may run from the substrate, e.g. the second metallization area, to a top electrode and to another top electrode and then to the substrate, e.g. the second metallization area, again, optionally via further top electrodes.

The interconnection structure may include one or more interconnection conductor, such as a wire, a ribbon and/or a clip. The interconnection conductor may be made from a metal alloy with at least one of copper and aluminum. The interconnection structure may correspond, e.g. in material, size, shape, or the like, to the bond structure or may be different therefrom. For example, one may consider one or more interconnection conductor made from an aluminum alloy and one or more bond conductor made from a copper alloy, or vice versa. There may be two or more interconnection conductors running electrically in parallel to one another.

One or more, all or each bond structure of the arrangement of bond structures may include one or more bond conductors, such as wires, ribbons and/or clips. The one or more bond conductors may be made from a further metal alloy with at least one of copper and aluminum. The metal alloy and the further metal alloy have specific conductance values which are equal or different by ± 10%.

A cross-sectional size, e.g. diameter and/or sum of all cross-sectional areas, of the interconnection structure, particularly the interconnection conductor(s), may be equal to or smaller than a cross-sectional size, e.g. diameter and/or sum of all cross-sectional areas, of the bond structure, particularly the bond conductor(s), that wire(s) one of the top electrodes. For example, the interconnection structure may have similar or increased electrical resistance relative to adjacent bond conductor(s). The bond structure and the interconnection structure, particularly their respective conductors, may have substantially the same total cross-sectional areas, or may have different total cross-sectional areas .

It may be that the interconnection structure connects or interconnects more than two power semiconductor devices, e.g. with at least or only partly presence of the angle between the first and the second wiring direction, e.g. different main orientations of respective bond structures. In other words, for example, the interconnection structure may connect three or more chips, of which merely two or more chips have bond structures that are obliquely arranged to one another.

There may be at least two, three four, five, or six, or more, and/or up to twenty bond conductors per top electrode and/or per bond structure. The bond conductors of each bond structure may at least substantially run along the same direction, e.g. their individual directions deviating by up to ± 45° or by up to 30° or by up to ± 20°, e.g. with exceptions. For example, the wiring direction of a bond structure may be defined from an average or equalization of wiring directions of the bond conductors. Wiring directions may be estimated in a top view onto the substrate structure.

The top metallization layer may have a third metallization area. The module may comprise a further arrangement of semiconductor devices or two or more further arrangements of semiconductor devices. Each semiconductor device of the further arrangement may have a top electrode facing away from the substrate structure and a bottom electrode arranged on the third metallization area. The semiconductor devices of the further arrangement may be a similar type or a different type relative to the semiconductor devices of the arrangement. There may be two or more of such further arrangements, each further arrangement including two or more semiconductor devices.

The module may comprise a further arrangement of bond structures or two or more further arrangements of bond structures. Each bond structure of said further arrangement may be configured for wiring one of the top electrodes of the further arrangement of semiconductor devices to the first metallization area. The further arrangement of bond structures may correspond in size, material, shape, number of conductors or the like to the arrangement of bond structures. The respective bond structures can connect top electrodes of semiconductor devices, especially that of a further arrangement of semiconductor devices, with the first or a further metallization area.

The arrangement of semiconductor devices may provide one of a low side and a high side and the further arrangement of semiconductor devices may provide the other one of the low side and the high side of a half-bridge. For example, the further arrangement of semiconductor devices may provide the high side. In their electrical interconnection, the arrangement and further arrangement may provide a half-bridge.

The arrangement of semiconductor devices, specifically each of the arrangements, may include a certain number, such as exactly two, semiconductor devices of a similar type. The further arrangement of semiconductor devices, specifically each of the further arrangements, may include a certain number, such as exactly two, semiconductor devices of a similar type. Two or more arrangements of semiconductor devices and/or two or more further arrangements of semiconductor devices can be provided. Within an arrangement or a further arrangement, the respective semiconductor devices may be arranged adjacently to one another. Each (further) arrangement of semiconductor devices may be formed as a group of adjacent or neighbouring semiconductor devices. Arrangements may be arranged at a distance to one another.

The bond structures of the further arrangement of semiconductor devices do not necessarily have an angle with respect to each other, e.g. the wiring directions among bond structures of the further arrangement of semiconductor devices may be substantially in parallel to one another.

The arrangement of semiconductor devices and/or the further arrangement of semiconductor devices may include IGBT, MOSFET, and/or HEMT chips. The compatibility with different semiconductor technologies allows broad applicability.

One, two or more, or all of the semiconductor devices of the arrangement of semiconductor devices may have a similar rotational orientation about a normal axis of the substrate structure. Alternatively or additionally, one, two or more, or all of the semiconductor devices of the further arrangement of semiconductor devices may have a similar rotational orientation about a normal axis of the substrate structure.

For example, in a top view, semiconductor devices may have the same orientation of the top electrode by 10° or by 5° or by 2° or less.

Generally, semiconductor devices may be rotated in respect to one another. One, two or more, or all of the semiconductor devices of the arrangement of semiconductor devices may have a different rotational orientation about a normal axis of the substrate structure. Alternatively or additionally, one, two or more, or all of the semiconductor devices of the further arrangement of semiconductor devices may have a different rotational orientation about a normal axis of the substrate structure. For example, in a top view, semiconductor devices may have an orientation of the top electrode which is rotated in respect to one another by 90° ± 10° or a multiple of 90° ± 10° .

For example, side edges of, particularly adjacent, semiconductor devices may run at least substantially in parallel to one another. The semiconductor devices may have side edges running substantially parallel to one another and/or side by side, particularly the side edges of adjacent semiconductor devices running parallel to one another and/or side by side. This is beneficial to compactness. Aligning semiconductor devices in a consistent orientation may improve manufacturability and thermal performance.

The object is furthermore solved by means of a use of an interconnection structure in a power semiconductor module, wherein the interconnection structure is configured for wiring at least two top electrodes of an arrangement of semiconductor devices of the power semiconductor module directly to one another. For example, the interconnection structure is applied to the semiconductor devices forming a low side of a half-bridge.

### Brief description of drawings

These and other aspects of the invention will be apparent from and elucidated with reference to the implementations described hereinafter.

In the drawings:
Fig. 1 shows a section of a submodule that is part of a power semiconductor module in a top view;
Fig. 2A shows a section of a submodule in a top view;
Fig. 2B-D show sections of a submodule with individual configurations of an interconnection structure in top views;
Fig. 3 shows a cross section of Fig. 2B;
Fig. 4 shows a submodule of a power semiconductor device in a top view that includes a half bridge with two interconnection structures; and
Fig. 5A-D show sections of submodules in top views.

### Description of implementations

The description contains procedural or methodical aspects upon describing structural features of the power semiconductor module; the structural features can be understood well in that way. It is emphasized to the reader that such structural features can be lifted from the described context without hesitation or the question of an intermediate generalization to form aspects of the invention. It is also emphasized to the reader that any the structural features described in the following can be understood as individual aspects of the invention to distinguish from known solutions, despite being possibly lifted from the context. The figures are not necessarily drawn to scale.

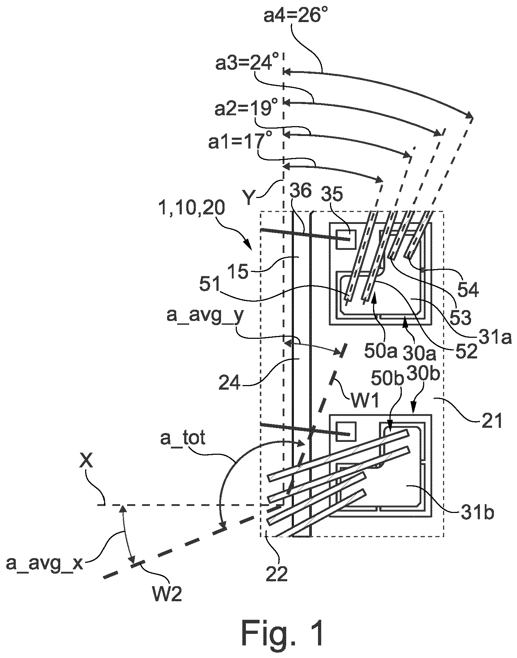

**Fig. 1** shows a section of a power semiconductor module, namely a submodule 1 of the power semiconductor module.

As can be seen in the top view, the submodule 1 comprises a substrate structure 10, an arrangement of semiconductor devices 30a, 30b, e.g. MOSFET or IGBT chips, and an arrangement of bond structures 50a, 50b, e.g. source bond structures for MOSFET chips or emitter bond structures for IGBT chips.

The arrangement of semiconductor devices 30a, 30b has two semiconductor devices 30a, 30b; the arrangement may comprise more than two semiconductor devices.

The arrangement of bond structures 50a, 50b has two bond structures 50a, 50b; the arrangement may comprise more than two bond structures.

The substrate structure 10 has a top metallization layer 20. The top metallization layer 20 is divided by isolation grooves 24 into different metallization areas. Here, there is a first metallization area 21 and a second metallization area 22. The top metallization layer 20 is provided on an insulation layer 15.

The arrangement of semiconductor devices 30a, 30b comprises two semiconductor devices 30a, 30b. The semiconductor devices 30a, 30b of the arrangement are connected electrically in parallel in respect to the metallization areas 21, 22. The semiconductor devices 30a, 30b of the arrangement are of a similar type, e.g. IGBT chips and/or MOSFET chips and/or other chips.

The semiconductor devices 30a, 30b have a top electrode 31a, 31b and a gate electrode 35 facing away from the substrate structure 10 and a bottom electrode 34 arranged on the first metallization area 21.

The bottom electrode 34 may be a drain electrode in the case of a MOSFET or a collector in the case of an IGBT.

The top electrode 31a, 31b may be a source in the case of a MOSFET or an emitter in the case of an IGBT.

Not shown in detail in **Fig. 1** is an interconnection structure configured for wiring at least two top electrodes 31a, 31b of the arrangement of semiconductor devices 30a, 30b directly to one another.

The semiconductor devices 30a, 30b are bonded in an electrically conductive manner, e.g. soldered, to the first metallization area 21.

The gate electrodes 35 may be connected to another section of the substrate structure 10 via a gate connection structure 36.

The arrangement of bond structures 50a, 50b comprises one bond structure 50a or 50b per semiconductor device 30a or 30b, respectively. Thus, there are two bond structures 50a, 50b shown in **Fig. 1****.** The bond structures 50a or 50b are each configured for wiring one of the top electrodes 31a or 31b, respectively, to the second metallization area 22.

Each of the bond structures 50a, 50b extends or wires along one of two wiring directions W1, W2, in this case by means of four bond conductors 51, 52, 53, 54 in each case. Particularly, a bond structure 50 may comprise or consist of one or more single electrically parallel bond conductors 51.

The wiring directions W1, W2 may relate to an average of the individual paths or directions along which individual bond conductors 51, 52, 53, 54 extend. The wiring directions W1, W2 typically extend substantially in parallel to a plane of the substrate structure 10.

Each bond structure 50a, 50b includes four bond conductors 51, 52, 53, 54, especially wires, that are made from a further metal alloy with at least one of copper and aluminum. In other embodiments, there may be at least one and/or up to twenty or more bond conductors.

It is noted that 'further' in 'further metal alloy' merely relates to a name for identification of the specific 'metal alloy' mentioned herein, since in this disclosure there are two 'metal alloys' mentioned to be distinguished from one another. If there is a 'further metal alloy' claimed or described, it does not necessarily mean that a 'metal alloy' must be present. This logic may be applied in any case of this disclosure where the term 'further' is used.

For reference, perpendicular and imaginary axes X and Y are shown in **Fig. 1** that extend in a plane substantially in parallel to a plane of the substrate structure 10.

Each of the bond conductors 51, 52, 53, 54 is inclined in respect to the axis X or Y, respectively, by an angle a1, a2, a3, or a4, respectively.

For example, for one semiconductor device 30a or 30b, in **Fig. 1** the above device 30a, the bond conductors 51, 52, 53, 54 are inclined in respect to the axis Y by an angle a_avg_y, particularly wherein a_avg_y = (a1+a2+a3+a4)/4. The angle a_avg_y is 21.5°, for example.

For example, for another semiconductor device 30a or 30b, in **Fig. 1** the below device 30b, the bond conductors are inclined in respect to the axis X by the angle a_avg_x, particularly wherein a_avg_x = a_avg_y.

The angles a_avg_x, a_avg_y among the semiconductor devices 30a, 30b of the arrangement do not need to be the same and may be different.

In other embodiments, it may be that any or all bond conductor(s) of a bond structure may assume an individual angle in respect to the axis X or Y, which individual angle can have a positive or negative value. The individual angles may provide an average angle in respect to the axis X or Y, such as said angle a_avg_x or a_avg_y, particularly which average angle could thus be positive or negative.

An angle a_tot between a first W1 and a second W2 wiring directions of the two wiring directions W1, W2 is at least 30° and up to 150°.

In this case, the angle a_tot is a_avg+a_avg+90°. In this case, the angle a_tot is approximately 133° which is at least 30° and up to 150°.

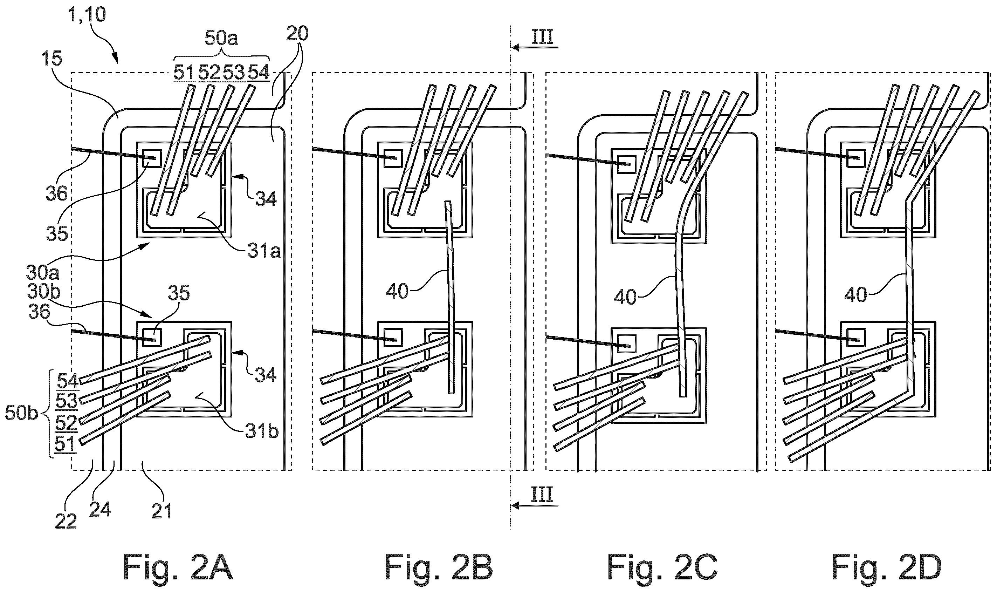

**Fig. 2A-D** show different power semiconductor modules 1 which substantially correspond to the submodule 1 shown in **Fig. 1** such that it can be referred to the respective description for same or similar features.

The modules 1 of Fig. 2B-D further include an interconnection structure 40. The interconnection structure 40 is configured for wiring or wires two top electrodes 31a, 31b of the arrangement of semiconductor devices 30a, 30b directly to one another. The interconnection structure 40 includes one or more interconnection conductor, especially a wire, that is made from a metal alloy with at least one of copper and aluminum.

The one or more interconnection conductor may comprise a similar material and/or cross-sectional size as the bond conductor(s) 51, 52, 53, 54.

A cross-sectional size of the interconnection structure 40, particularly of the interconnection conductor, is equal to or smaller than a cross-sectional size of the bond conductors 51, 52, 53, 54 that wire one of the top electrodes 31a, 31b. The cross-sectional size of the bond conductors 51, 52, 53, 54 may be considered as the sum of a number, in this case four, of individual cross-sectional sizes.

In **Fig. 2B****,** the interconnection structure 40 only wires the two top electrodes 31a and 31b of the arrangement of semiconductor devices 30a and 30b directly to one another. Particularly, the interconnection structure 40 directly connects chip to chip only. Particularly, both ends of the interconnection structure 40 can each be located on one top electrode. One end is on the top electrode 31a and the other end is on the other top electrode 31b.

In **Fig. 2C****,** the interconnection structure 40 is configured for wiring the two top electrodes 31a, 31b of the arrangement of semiconductor devices 30a, 30b directly to one another. The interconnection structure 40 is further configured for wiring the second metallization area 22 directly to one of the top electrodes 31a and 31b. Particularly, the interconnection structure 40 directly connects chip to chip to substrate 10 only, particularly directly and in series. Particularly, one end of the interconnection structure 40 can be located on a top electrode 31a or 31b and the other end of the interconnection structure 40 can be located on the top metallization layer 20, particularly the second metallization area 22.

In **Fig. 2D****,** the interconnection structure 40 is configured for wiring the two top electrodes 31a, 31b of the arrangement of semiconductor devices 30a, 30b directly to one another. The interconnection structure 40 is further configured for wiring the second metallization area 22 directly to one of the top electrodes 31a, 31b. The interconnection structure 40 is further configured for wiring the second metallization area 22 directly to another one or the other one of the top electrodes 31a, 31b. Particularly, the interconnection structure 40 connects substrate 10 chip to chip to substrate 10 only, particularly directly and in series. Particularly, one end of the interconnection structure 40 can be located on the top metallization layer 20, particularly the second metallization area 22, and the other end of the interconnection structure 40 can be located on the top metallization layer 20, particularly the second metallization area 22, especially in a different location relative to said one end.

Generally, an interconnection structure, especially its interconnection conductor(s), and/or a bond structure, especially its bond conductor(s), may be bonded, e.g. soldered or sintered, e.g. to one or more of a top electrode and/or metallization area.

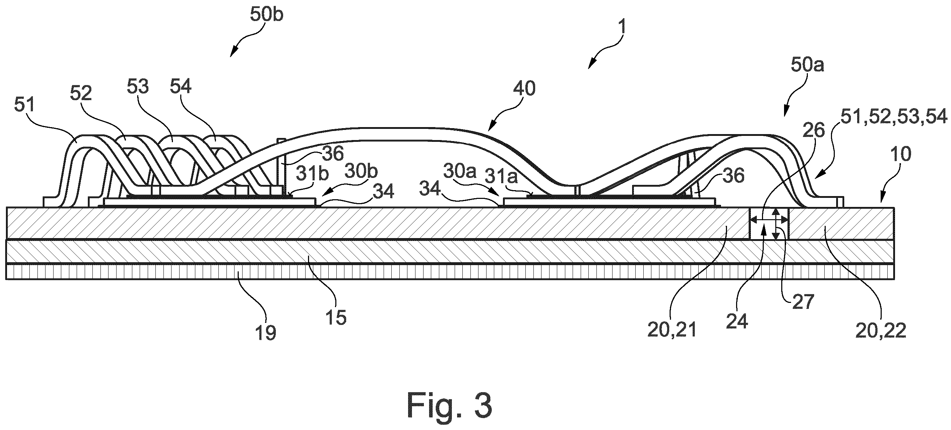

**Fig. 3** shows a section as indicated in **Fig. 2B****.** As can be seen in the section, the substrate structure 10 has the insulation layer 15 with the top metallization layer 20 and with a bottom metallization layer 19 opposite the top metallization layer 20. The insulation layer 15 comprises for electrical insulation a ceramic material or a resin sheet. The top metallization layer 20 and the bottom metallization layer 19 comprise e.g. a copper alloy. The insulation layer 15 isolates the layers 19 and 20 from one another.

The top metallization layer 20 includes the metallization areas 21, 22 as shown in **Fig. 3****.** The top metallization layer 20 includes an isolation groove 24 between the adjacent metallization areas 21 and 22 to electrically separate them from one another. The isolation groove 24 has a width 26 of 0.5 mm or more. The top metallization layer 20 has a thickness of at least 0.1 mm. The isolation groove 24 has a depth 27 of at least 0.1 mm, e.g. which corresponds to the thickness of the top metallization layer 20.

The semiconductor devices 30a, 30b are arranged, particularly adjacently, on the top metallization layer 20, especially soldered or sintered thereto.

Each of the semiconductor devices 30a, 30b, specifically the respective top electrode 31a, 31b, is wired to the second metallization area 22 by means of one of the bond structures 50a, 50b. All four bond conductors 51, 52, 53, 54 of each bond structure 50a, 50b are arranged electrically in parallel.

The semiconductor devices 30a, 30b, specifically their top electrodes 31a, 31b, are wired directly to another by means of the interconnection structure 40. For example, the interconnection structure 40 is directly connected and/or soldered to the top electrodes 31a, 31b.

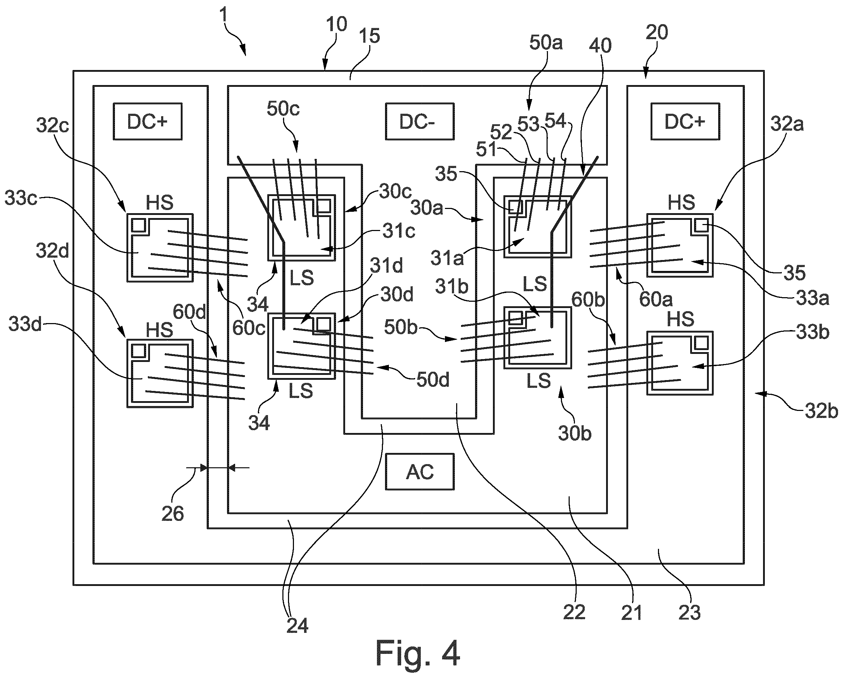

**Fig. 4** shows a submodule 1 of a power semiconductor module with a substrate structure 10 and designed at least in parts similar to that of **Fig. 2C****.** The substrate structure 10 of **Fig. 4** has a top metallization layer 20 that has or is divided in a first 21, a second 22, and a third 23 metallization area, e.g. such that a half-bridge configuration is provided. Gate electrodes of each power semiconductor device 30a, 30b, 30c, 30d connect to a gate metallization pattern or gate loop via gate connection structure which is not shown in detail. The gate electrodes are not shown in detail. The gate metallization pattern or gate loop is not shown in detail. The top metallization layer 20 is bonded onto an insulation layer 15.

Two arrangements of two semiconductor devices 30a, 30b, 30c, 30d are provided, particularly for the low side. In total, four devices 30a, 30b, 30c, 30d are provided, particularly for the low side, wherein each arrangement includes either semiconductor devices 30a and 30b or semiconductor devices 30c and 30d.

The submodule 1 has a space saving arrangement of the arrangements forming the low side, where it can be understood that a main orientation of the bond structure 50a/50c of one semiconductor device 30a/30c is rotated with respect to the bond structure 50b/50d of the other semiconductor device 30b/30d. This saves space in the center of the submodule 1, cf. **Fig. 4****.** A drawback of such a layout may be that the switching behavior of the power semiconductor module can get worse due to more unbalanced electromagnetic gate couplings which can be originated by a time-dependent magnetic field generated by a change of the emitter or source current. A magnetic field generated by the change of current during switching may couple into the gate loop. In order to encounter such drawbacks, the interconnection structures 50 are provided to interconnect top electrodes 31a and 31b or 31c and 31d, e.g. sources or emitters, of respective arrangements.

Generally, interconnection structures 40 may provide that a better balance of gate couplings can be achieved.

The devices 30a, 30b, 30c, 30d are substantially identical, e.g. are IGBT chips or MOSFET chips. Both arrangements are arranged electrically substantially in parallel in respect to the metallization layers 21, 22. Each arrangement has two devices, namely 30a and 30b or 30c and 30d, respectively, which are arranged substantially adjacent to one another, e.g. are arranged at a distance of no more than 200 % of an extension of the devices 30, cf. **Fig. 4****.**

It can be understood, in other words, for example, that there are two groups of each two devices 30a/30b and 30c/30d. In other embodiments, more than two devices may be provided per arrangement, wherein said more than two devices can be provided with an interconnection structure.

Each semiconductor device 30a, 30b, 30c, 30d has a top electrode 31a, 31b, 31c, 31d facing away from the substrate structure 10 and a bottom electrode 34, e.g. drain or collector, arranged on the first metallization area 21. The bottom electrode is substantially arranged between the respective top electrode 31, 31a, 31b, 31c, 31d and the insulation layer 15, particularly the top metallization layer 20, cf. also **Fig. 3** in respect to bottom electrode 34.

For example, two arrangements of bond structures 50a, 50b, 50c, 50d are provided, wherein each arrangement includes the bond structure 50a and the bond structure 50b, or the bond structure 50c and the bond structure 50d.

One arrangement of bond structures 50a, 50b, 50c, 50d is provided for each arrangement of semiconductor devices 30a, 30b, 30c, 30d such that within a respective arrangement one bond structure 50a, 50b, 50c or 50d is assigned to one semiconductor device 30a, 30b, 30c or 30d of the other respective arrangement.

Each bond structure 50a, 50b, 50c, 50d is connected to or is assigned to a certain top electrode 31a, 31b, 31c, 31d of the respective arrangement of semiconductor devices 30a, 30b, 30c, 30d.

Each bond structure 50a, 50b, 50c, 50d includes at least one and/or up to twenty, particularly four, bond conductors 51, 52, 53, 54, e.g. in the form of wires and is configured for wiring one of the top electrodes 31 to the second metallization area 22 along one of two wiring directions. An angle between a first and a second wiring direction of the two wiring directions is at least 30° and up to 150°. Specifically, said angle may be 90° ± 45° or 90° ± 20°.

The submodule 1 of **Fig. 4** comprises two further arrangements of semiconductor devices 32, each further arrangement having two semiconductor devices 32a and 32b or 32c and 32d, respectively. The devices 32a, 32b, 32c, 32d are substantially identical, e.g. are MOSFET chips. Both further arrangements are arranged electrically substantially in parallel in respect to the metallization layers 21, 23. Each further arrangement has two devices 32a and 32b or 32c and 32d which are arranged substantially adjacent to one another. These two further arrangements form the high side of the half-bridge.

Each semiconductor device 32a, 32b, 32c, 32d has a top electrode 33a, 33b, 33c, 33d facing away from the substrate structure 10 and a bottom electrode 34 arranged on the third metallization area 23.

Two further arrangements of bond structures 60a, 60b, 60c, 60d are provided, each further arrangement having two bond structures 60a and 60b or 60c and 60d, respectively. One further arrangement of bond structures 60a, 60b, 60c, 60d is provided for each further arrangement of semiconductor devices 32a, 32b, 32c, 32d such that one bond structure 60a, 60b, 60c or 60d is assigned to one semiconductor device 32a, 32b, 32c or 32d.

Each bond structure 60a, 60b, 60c, 60d is connected to or is assigned to a certain top electrode 33a, 33b, 33c, 33d. Each bond structure 60a, 60b, 60c, 60d includes four bond conductors, e.g. in the form of wires, and is configured for wiring one of the top electrodes 33a, 33b, 33c, 33d to the third metallization area 23 particularly along one of two or more wiring directions; an angle between a first and a second wiring direction of the two or more wiring directions may be substantially zero as shown in **Fig. 4****.**

The further arrangements of bond structures 60a, 60b, 60c, 60d may correspond to the arrangements of bond structures 50a, 50b, 50c, 50d . Particularly, one or more or all of the bond structures 60a, 60b, 60c, 60d may be built with similar features, e.g. in respect to cross-sectional shape, number of wires, material, or the like, compared to the bond structures 50a, 50b, 50c, 50d.

The further arrangements of semiconductor devices 32a, 32b, 32c, 32d may correspond to the arrangement of semiconductor devices 30a, 30b, 30c, 30d. Particularly, one or more or all of the semiconductor devices 32a, 32b, 32c, 32d may be built with similar features, e.g. in respect to type, material, size, electrical characteristics, or the like, compared to the semiconductor devices 30a, 30b, 30c, 30d.

Interconnection structures 40 are provided which are configured for wiring two top electrodes 31a and 31b and/or 31c and 31d of one arrangement of semiconductor devices 30a and 30b or 30c and 30d directly to one another and furthermore to the second metallization layer 22. Here, the interconnection structures 40 correspond to the embodiment of Fig. 2C. Here, on end of the interconnection structure 40 is on the semiconductor device 30b or 30d and the other end is on the top metallization layer 20.

The first metallization area 21 is configured to provide an AC terminal, the second metallization area 22 is configured to provide a DC- terminal, and the third metallization area 23 is configured to provide a DC+ terminal. The arrangements of semiconductor devices 30a, 30b, 30c, 30d provide a low side. The further arrangements of semiconductor devices 32a, 32b, 32c, 32d provide a high side. A half-bridge configuration is provided

The two semiconductor devices 30a and 30b or 30c and 30d, respectively, of each arrangement have a similar rotational orientation about a normal axis of the substrate structure 10. This is remarkable despite the bond structures 50a and 50b or 50c and 50d, respectively, exhibiting different wiring directions. The arrangements are arranged on opposite sides in respect to the second metallization area 22.

The two semiconductor devices 32a and 32b or 32c and 32d, respectively, of each further arrangement have a similar rotational orientation about a normal axis of the substrate structure 10. The further arrangements are arranged on opposite sides in respect to the second metallization area 22 and in respect to the first metallization area 21.

In respect to **Fig. 4****,** the substrate structure 10 has an insulation layer 15 with the top metallization layer 20, optionally with a bottom metallization layer opposite the top metallization layer 20. The insulation layer 15 comprises for electrical insulation a ceramic material or a resin sheet. The top metallization layer 20 and/or the bottom metallization layer comprise(s) or consist(s) of copper, aluminum or an alloy therewith.

The top metallization layer 20 has a thickness of at least 0.1 mm and includes an isolation groove 24 between adjacent metallization areas 21, 22, 23, which isolation groove 24 has a width 26 of 0.5 mm or more.

In respect to **Fig. 4** it can be stated that electro-magnetic and electro-thermal simulations were done to show improvements due to the introduction of the interconnection structures 40 between two electrically parallel chips having source bonds with main orientations of 90° ± 45° with respect to each other. The simulations were done on a power module design with half-bridge configuration as shown in **Fig. 2C** or **Fig. 4** having two arrangements of each two low side semiconductor devices 30a/30b and 30c/30d, where the top electrodes 30a/30b and 30c/30d of within respective arrangements are interconnected by the interconnection conductors. It can be summarized that without the interconnection structures 40 gate coupling inductances, e.g. that of devices 30a and 30b, ranges between -0.15 nH and -0.40 nH, which may result in an inhomogeneous switching behavior. Upon introducing the interconnection structures 40 as shown in **Fig. 4****,** the gate coupling inductances, e.g. that of devices 30a and 30b, ranges between -0.22 nH and -0.30 nH. As such, the interconnection structure 40 can reduce the difference in coupling inductance values within the low side from 0.25 nH to 0.08 nH. Additionally, introduction of the interconnection structures 40 contributed to reduce temperatures of the source bonds, thereby providing thermal advantages.

Shown and described is a use of an interconnection structure 40 in a power semiconductor module, particularly in a submodule 1 thereof, wherein the interconnection structure 40 is configured for wiring at least two top electrodes 31a, 31b, 31c, 31d of an arrangement of semiconductor devices 30a, 30b, 30c, 30d directly to one another.

In **Fig. 4****,** the semiconductor devices 30a, 30b, 30c, 30d of the low side are indicated with a reference sign 'LS'. The semiconductor devices 32a, 32b, 32c, 32d of the high side are indicated with a reference mark 'HS'. The electric potential of the first 21, second 22, and third 23 metallization areas is indicated by reference mark 'AC' (i.e. alternating current), 'DC-' (i.e. direct current negative), and 'DC+' (i.e. direct current positive), respectively.

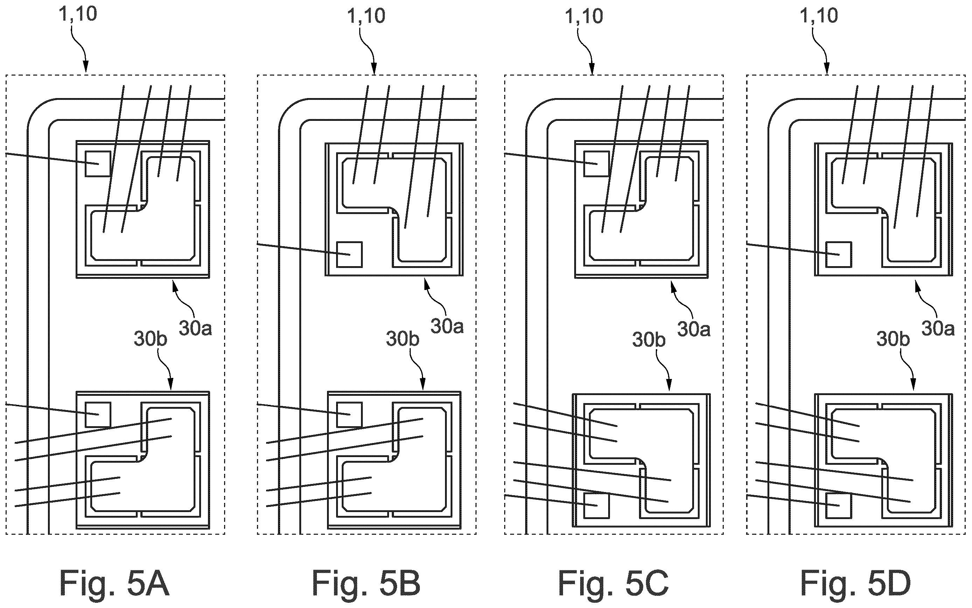

Fig. 5A-D show different power semiconductor modules 1 which substantially correspond to the submodule 1 shown in **Fig. 1** such that it can be referred to the respective description for same or similar features.

Among Fig. 5A-D, the semiconductor devices 30a, 30b exhibit specific differences in their rotational orientations. Generally, side edges of the adjacent semiconductor devices 30a, 30b run in parallel to one another.

In Fig. 5A-B, respectively, the two semiconductor devices 30a, 30b of the arrangement of semiconductor devices 30a, 30b have a similar rotational orientation about the normal axis of the substrate structure 10.

In Fig. 5C-D, respectively, the two semiconductor devices 30a, 30b of the arrangement of semiconductor devices 30a, 30b have a different rotational orientation about the normal axis of the substrate structure 10. In each case, the orientation of the devices 30a, 30b is rotated in respect to one another by 90°.

It is noted that aspects of the above described and shown embodiments may be combined.

### Reference signs list

- 1: submodule
- 10: substrate structure
- 15: insulation layer
- 19: bottom metallization layer
- 20: top metallization layer
- 21: first metallization area
- 22: second metallization area
- 23: third metallization area
- 24: isolation groove
- 26: width of isolation groove
- 27: depth of isolation groove
- 30a-d: semiconductor devices
- 31a-d: top electrode
- 32a-d: semiconductor device
- 33a-d: top electrode
- 34: bottom electrode
- 35: gate electrode
- 36: gate connection structure
- 40: interconnection structure
- 50a-d: bond structure
- 51-54: bond conductor
- 60a-d: bond structure
- W1: first wiring direction
- W2: second wiring direction
- a: angle
- X: axis
- Y: axis

## Claims

1. Power semiconductor module comprising
a substrate structure (10) with a top metallization layer (20) having a first metallization area (21) and a second metallization area (22);
an arrangement of semiconductor devices (30a, 30b) each having a top electrode (31a, 31b) facing away from the substrate structure (10) and a bottom electrode arranged on the first metallization area (21); and
an arrangement of bond structures (50a, 50b) each configured for wiring one of the top electrodes (31a, 31b) to the second metallization area (22) along one of two or more wiring directions (W1, W2), wherein an angle (a_tot) between a first and a second wiring direction (W1, W2) of the two or more wiring directions (W1, W2) is at least 30° and up to 150°.
**characterized by**
an interconnection structure (40) configured for wiring at least two top electrodes (31a, 31b) of the arrangement of semiconductor devices (30a, 30b) directly to one another.

2. Module according to the preceding claim, **characterized in that**
the angle (a_tot) is at least 60° and up to 120°, and particularly the angle (a_tot) is 90° ± 20° or 90° ± 10°.

3. Module according to one of the preceding claims, **characterized in that**
the interconnection structure (40) is configured for wiring the second metallization area (22) directly to one of the top electrodes (31a, 31b), and optionally
the interconnection structure (40) is configured for wiring the second metallization area (22) directly to another one of the top electrodes (31a, 31b).

4. Module according to one of the preceding claims, **characterized in that**
the interconnection structure (40) includes one or more interconnection conductor, such as a wire, a ribbon and/or a clip, and made from a metal alloy with at least one of copper and aluminum.

5. Module according to the preceding claim, **characterized in that**
each bond structure (50a, 50b) of the arrangement of source bond structures (50a, 50b) includes bond conductors (51, 52, 53, 54), such as wires, ribbons and/or clips, and made from a further metal alloy with at least one of copper and aluminum; and particularly
the metal alloy and the further metal alloy have specific conductance values which are equal or different by ± 10%.

6. Module according to the preceding claim, **characterized by**
a cross-sectional size of the interconnection structure (40) is equal to or smaller than a cross-sectional size of the bond conductor(s) (51, 52, 53, 54) that wire(s) one of the top electrodes (31a, 31b).

7. Module according to one of the preceding two claims, **characterized by** up to twenty, particularly two, three four, five, or six, bond conductors (51, 52, 53, 54) per top electrode (31a, 31).

8. Module according to one of the preceding claims, **characterized by**
the top metallization layer (20) having a third metallization area (23),
the module (1) comprising a further arrangement of semiconductor devices (32a, 32b, 32c, 32d) of which each semiconductor device (32a, 32b, 32c, 32d) has a top electrode (33a, 33b, 33c, 33d) facing away from the substrate structure (10) and a bottom electrode arranged on the third metallization area (23);
the module (1) comprising a further arrangement of bond structures (60a, 60b, 60c, 60d) of which each bond structure (60a, 60b, 60c, 60d) is configured for wiring one of the top electrodes (33a, 33b, 33c, 33d) to the first metallization area (21), particularly the further arrangement of bond structures (60a, 60b, 60c, 60d) corresponding in at least one of material, size and shape to the arrangement of bond structures (50a, 50b, 50c, 50d).

9. Module according to the preceding claim, **characterized in that**
the arrangement of semiconductor devices (30a, 30b, 30c, 30d) provides one of a low side and a high side and the further arrangement of semiconductor devices (32a, 32b, 32c, 32d) provides the other one of the low side and the high side.

10. Module according to one of the preceding two claims, **characterized by**
the arrangement of semiconductor devices (30a, 30b, 30c, 30d) including exactly two semiconductor devices (30a, 30b, 30c, 30d) of a similar type, and optionally
the further arrangement of semiconductor devices (32a, 32b, 32c, 32d) including exactly two semiconductor devices (30a, 30b, 30c, 30d) of a similar type, and optionally wherein
two or more arrangements of semiconductor devices (30a, 30b, 30c, 30d) and/or two or more further arrangements of semiconductor devices (32a, 32b, 32c, 32d), are provided.

11. Module according to one of the preceding claims, **characterized in that**
the arrangement of semiconductor devices (30a, 30b, 30c, 30d) and, if present, the further arrangement of semiconductor devices (32a, 32b, 32c, 32d), includes IGBT, MOSFET, or HEMT chips.

12. Module according to one of the preceding claims, **characterized in that**
the semiconductor devices (30a, 30b, 30c, 30d) of the arrangement and/or the semiconductor devices (32a, 32b, 32c, 32d) of the further arrangement
have a similar rotational orientation about a normal axis of the substrate structure (10), and/or
have side edges running substantially parallel to one another, particularly the side edges of adjacent semiconductor devices (30a, 30b, 30c, 30d) running parallel to one another.

13. Module according to one of the preceding claims, **characterized in that**
the substrate structure (10) has an insulation layer (15) with the top metallization layer (20), optionally with a bottom metallization layer opposite the top metallization layer (20);
the insulation layer (15) comprises for electrical insulation a ceramic material or a resin sheet; and
the top metallization layer (20) and, if present, the bottom metallization layer comprise(s) or consist(s) of copper, aluminum or an alloy therewith.

14. Module according to one of the preceding claims, **characterized in that**
the top metallization layer (20) has a thickness of at least 0.1 mm; and
the top metallization layer (20) includes an isolation groove (24) between adjacent metallization areas (21, 22, 23), which isolation groove (24) has a width (26) of 0.5 mm or more.

15. Use of an interconnection structure (40) in a module according to the preamble of claim 1, wherein the interconnection structure (40) is designed corresponding to the characterizing part of claim 1.
